# EUROPÄISCHE PATENTSCHRIFT

(11) **EP 2 132 354 B1**
(45) Veröffentlichungstag und Bekanntmachung des Hinweises auf die Patenterteilung: **10.04.2013**
(21) Anmeldenummer: 08748690.8
(22) Anmeldetag: 28.02.2008
(51) Int. Cl.: B01J 4/00, F16J 15/16, C23C 16/54, C23C 14/56

(54) **VERFAHREN UND VORRICHTUNG ZUR BEHANDLUNG BANDFÖRMIGEN SUBSTRATES IN EINER VAKUUMBESCHICHTUNGSANLAGE**
METHOD AND APPARATUS FOR THE TREATMENT OF STRIP-SHAPED SUBSTRATE IN A VACUUM COATING SYSTEM
PROCÉDÉ ET DISPOSITIF DE TRAITEMENT DE SUBSTRAT EN BANDE DANS UNE INSTALLATION D'APPLICATION DE REVÊTEMENT SOUS VIDE

(30) Priorität: 28.02.2007 DE 102007010135
(43) Veröffentlichungstag der Anmeldung: 16.12.2009
(73) Patentinhaber: VON ARDENNE Anlagentechnik GmbH, 01324 Dresden (DE)
(72) Erfinder: GOTTSMANN, Lutz, 01900 Kleinroehrsdorf (DE); LAIMER,Georg, 01662 Meissen (DE); JAEGER, Reinhard, 01640 Coswig (DE)
(74) Vertreter: Lippert, Stachow & Partner
(86) Internationale Anmeldenummer: PCT/DE2008/000348
(87) Internationale Veröffentlichungsnummer: WO 2008/104169

(56) Entgegenhaltungen:
- DE-C1- 4 240 490
- DE-T2-602004 001 403
- US-A- 3 640 543

## Beschreibung

Die Erfindung betrifft ein Verfahren zur Behandlung bandförmigen Substrates in einer Vakuumbeschichtungsanlage, wobei das bandförmige Substrat auf einer Transportlinie durch die Vakuumbeschichtungsanlage, deren Vakuumbereiche mittels Schleusen, die zumindest eine die Oberseite des Substrates abdichtende obere Schleusenkomponente und eine die Unterseite des Substrates abdichtende untere Schleusenkomponente aufweisen, abgetrennt sind, transportiert wird und wobei die Schleusen zeitweise geöffnet werden.

Die Erfindung betrifft auch eine Vorrichtung zur Behandlung bandförmigen Substrates in einer Vakuumbeschichtungsanlage mit einem durch eine Eingangs- und eine Ausgangsschleuse abgedichteten Vakuumbereich, der mit Vakuumerzeugern verbunden ist, wobei jede Schleuse eine obere Schleusenkomponente, die oberhalb des Substrates angeordnet ist, und eine untere Schleusenkomponente, die unterhalb des Substrates angeordnet ist, aufweist.

Bandschleusen sind bei air-to-air-Vakuumbeschichtungsanlagen notwendig, um kontinuierlich Metallband von Atmosphäre in Vakuumprozessbehälter hinein bzw. aus Vakuumprozessbehältern heraus zu transferieren, ohne dass der erforderliche Prozessdruck des der Bandeingangsschleusensektion folgenden bzw. vor der Bandausgangsschleusensektion befindlichen Vakuumbehälters beeinflusst wird. Bandschleusen nach verschiedenen Prinzipien sind in DE 0 388 811 A1, DE 2 260 683 A, DD 289 297 A5, DE 0 293 929 A1, EP 0 668 370 B1 und EP 1 004 369 B1 offenbart.

Bandschleusen nach dem Prinzip von Spaltgeometrie, bei denen ein Band als zu beschichtendes Substrat in der Ein- bzw. Ausgangschleuse einen oder mehrere Spalte durchläuft, sind technisch aufgrund extrem großer Leckagen und der damit verbundenen Notwendigkeit großer zu installierender Saugleistung der Vakuumpumpen kaum realisierbar.

Nach einem anderen Prinzip sind Bandschleusen mit mehreren rotierenden Dichtrollen vorgesehen, die in verschieden Ausführungsformen bekannt sind. Dabei wird das Grundprinzip jeweils durch eine Abdichtung sowohl zwischen Band und rotierender Dichtrolle als auch zwischen rotierender Dichtrolle und Ein- bzw. Ausgangschleusenbehälter gewährleistet. Es sind sowohl Dichtrollen mit gummierter als auch mit metallischer Oberfläche bekannt. Bei Bandschleusen dieser Art werden die Dichtrollen aufeinander gepresst, wobei sich die obere Dichtrolle und die untere Dichtrolle auf ein und demselben Rahmen befinden. Zur Gewährleistung einer ausreichenden Dichtheit ist eine hohe Präzision der Lage der Dichtrollen zueinander gefordert. Ein komplettes eingangsseitiges oder ausgangsseitiges Schleusensystem besteht meist jeweils aus mehreren Schleusenkomponenten mit dazwischen angeordneten Vakuumerzeugungseinrichtungen, wodurch ein mehrstufiges Schleusensystem gebildet wird.

Bei gummierten Rollen tritt insbesondere bei dickeren Bändern und hohen Durchlaufgeschwindigkeiten erhöhter Verschleiß auf. Schnelle Wechselzeiten der Schleusen sind deshalb für eine hohe Anlagenverfügbarkeit unabdingbar.

In der DE 60 2004 001 403 T2 ist eine Schleuse für eine Vakuumbandbeschichtungsanlage beschrieben, bei der die obere und die untere Rolle getrennt voneinander von dem bandförmigen Substrat entfernt werden können. Hierzu sind die Rollen über Rollenlager mit einem oberen und einem unteren Deckel der Vakuumbeschichtungsanlage verbunden. Bei der Instandhaltung der Kammer ist es somit möglich, einen leichten Zugang zu den Rollen zu erhalten, indem der obere Deckel zusammen mit der oberen Rolle oder der untere Deckel zusammen mit der unteren Rolle ohne eine Durchdringung der Transportebene jeweils oberhalb bzw. unterhalb der Substrats abgehoben werden können. Diese Lösung ist für einen Vereinfachung bei der Instandhaltung konzipiert. Eine Abhilfe bei dem Eintreten eines Defekts an der Schleuse bzw. einer Rolle während des Betriebs ist hier nicht vorgesehen.

Außerhalb der regulären Wartungszeiten sind Produktionsunterbrechungen wegen einzelner defekter Schleusen vermeidbar, wenn die defekte Schleuse derart geöffnet werden kann, dass keine Bändberührung mehr stattfindet.

Ein Nachteil der bisherigen Lösungen besteht darin, dass sämtliche Schleusenkomponenten oberhalb und unterhalb des Bandes in einem gemeinsamen Grundrahmen angeordnet sind. Ein kompletter Schleusenwechsel ist somit nur möglich, wenn das Band durchgeschnitten wird.

Nicht jede beliebige Schleuse ist derart zu öffnen, dass keine Bandberührung mehr stattfindet.

Es ist daher Aufgabe der Erfindung, eine Vorrichtung und ein Verfahren zum kontinuierlichen Transport bandförmiger meist metallischer Substrate von Atmosphäre in bzw. aus Vakuumprozessbehältern zu entwickeln, welche ohne Bandtrennung austauschbar und während des Betriebes zu öffnen ist.

Erfindungsgemäß wird die Aufgabe durch die unabhängigen Ansprüche 1 und 2 gelöst.

Gemäß der Erfindung sind somit sämtliche zu einer Schleusenkomponente gehörigen Bauteile welche sich oberhalb des Bandes befinden, an einem separaten Grundrahmen montiert. Dementsprechend sind alle zu einer Schleusenkomponente gehörigen Bauteile, welche sich unterhalb des Bandes befinden ebenfalls an einem eigenen Grundrahmen montiert. Während des Betriebes sind somit alle bandberührenden Teile der oberen und unteren Schleusenhälfte vom Band wegbewegbar, damit keine Bandberührung mehr stattfindet.

In einer Ausführungsform der Erfindung ist vorgesehen, dass die beiden Schleusenkomponenten unabhängig voneinander aus der Vakuumbeschichtungsanlage entnehmbar sind. Damit ist jede Schleusenhälfte ohne Bandtrennung demontierbar d.h. im Ganzen aus dem Vakuumbehälter zu entnehmen.

Ein weitere Ausführungsform der Erfindung sieht vor, dass die obere Schleusenkomponente mit einem oberen Grundrahmen, und die untere Schleusenkomponente mit einem unteren Grundrahmen verbunden ist, wobei der obere Grundrahmen die gesamte obere Schleusenkomponente und der untere Grundrahmen die gesamte untere Schleusenkomponente aufnimmt und die Grundrahmen voneinander separat angeordnet sind.

Im weiteren ist eine Ausgestaltung der Erfindung mit Dichtrollen vorgesehen. Dabei ist mit dem oberen Grundrahmen eine die Oberseite des Substrates abdichtende obere Dichtrolle und eine an der Mantelfläche der oberen Dichtrolle gleitende obere Dichtleiste sowie eine an die Gehäusewandung angreifende obere Dichtung verbunden. Weiterhin ist mit dem unteren Grundrahmen eine die Unterseite des Substrates abdichtende untere Dichtrolle und eine an der Mantelfläche der unteren Dichtrolle gleitende untere Dichtleiste sowie eine an die Gehäusewandung angreifende untere Dichtung verbunden. Die Mittelachsen der oberen und der unteren Dichtrolle weisen einen Abstand zueinander auf, der veränderbar ist. Die obere und die untere Dichtung liegen bei einem minimalen Abstand an je einer Dichtfläche der Gehäusewandung dichtend an.

Die Anordnung der Dichtrollen und der Dichtleiste ist dabei so gewählt, dass über die obere Dichtung, die obere Dichtleiste, einer Berührungslinie zwischen oberer Dichtleiste und Mantelfläche der oberen Dichtrolle und einer Berührungslinie zwischen oberer Dichtrolle und Oberseite des Substrates eine geschlossene obere Dichtlinie und über die untere Dichtung, die untere Dichtleiste, einer Berührungslinie zwischen unterer Dichtleiste und Mantelfläche der unteren Dichtrolle und einer Berührungslinie zwischen unterer Dichtrolle und Unterseite des Substrates eine geschlossene untere Dichtlinie entsteht.

Diese Ausführung kann dadurch ausgestaltet werden, dass die obere und die untere Dichtrolle jeweils eine Mantelfläche aus Stahl oder stahlähnlich hartem Material aufweisen. Die Gestaltung der Mantelfläche erlaubt es, dass die Dichtleisten direkt auf der Mantelfläche gleiten, wenn sich die Dichtrolle dreht, ohne dass die Mantelfläche oberflächlich zerstört wird, was durch die entsprechende Härte gegeben ist.

Zur Vermeidung eines direkten Angreifens der Dichtleisten an den Mantelflächen der jeweiligen Dichtrollen ist in einer weiteren Ausführung vorgesehen, dass mit dem oberen Grundrahmen eine die Oberseite des Substrates abdichtende obere Dichtrolle, eine an der Mantelfläche der oberen Dichtrolle anliegende obere Zwischenrolle und eine an der Mantelfläche der oberen Zwischenrolle gleitende obere Dichtleiste sowie eine an die Gehäusewandung angreifende obere Dichtung verbunden ist, dass mit dem unteren Grundrahmen eine die Unterseite des Substrates abdichtende untere Dichtrolle, eine an der Mantelfläche der unteren Dichtrolle anliegende untere Zwischenrolle und eine an der Mantelfläche der unteren Zwischenrolle gleitende untere Dichtleiste sowie eine an die Gehäusewandung angreifende untere Dichtung verbunden ist, dass die Mittelachsen der oberen und der unteren Dichtrolle einen Abstand zueinander aufweisen, der veränderbar ist und die obere und die untere Dichtung zumindest bei einem minimalen Abstand an je einer Dichtfläche der Gehäusewandung dichtend anliegen.

Hierbei ist die Anordnung der Dichtrollen, der Zwischenrollen und der Dichtleiste so gewählt, dass über die obere Dichtung, die obere Dichtleiste, einer Berührungslinie zwischen oberer Dichtleiste und Mantelfläche der oberen Zwischenrolle, der Berührungslinie zwischen oberer Zwischenrolle und oberer Dichtrolle und einer Berührungslinie zwischen oberer Dichtrolle und Oberseite des Substrates eine geschlossene obere Dichtlinie und über die untere Dichtung, die untere Dichtleiste, einer Berührungslinie zwischen unterer Dichtleiste und Mantelfläche der unteren Zwischenrolle, der Berührungslinie zwischen unterer Dichtleiste und Mantelfläche der unteren Dichtrolle und einer Berührungslinie zwischen unterer Dichtrolle und Unterseite des Substrates eine geschlossene untere Dichtlinie entsteht.

Bei dieser Ausführungsform ist es möglich, dass die obere und die untere Dichtrolle jeweils eine Mantelfläche aus elastischem Material und die obere und die untere Zwischenrolle jeweils eine Mantelfläche aus Stahl oder stahlähnlich hartem Material aufweisen.

Die Dichtleisten können auch als Schabermesser, ein sogenanntes Doctorblade, ausgebildet werden, um Verunreinigungen die an der Rolle haften, an die die Dichtleisten angreifen, zu entfernen. Es ist aber auch möglich, zusätzlich zu der Dichtleiste derartige Schabermesser vorzusehen. Insbesondere kann somit auch eine mit einer Mantelfläche aus flexiblem Material versehene Dichtrolle permanent gereinigt werden.

Die Dichtwirkung der Dichtungen kann zum einen durch eine Bewegung der Schleusenkomponenten in einer senkrecht zur Substratebene liegenden Richtung hervorgerufen werden. Hierfür ist vorgesehen, dass die Gehäusewandung mit einer quer zur Bewegungsrichtung der oberen Schleusenkomponente liegenden obere Dichtfläche auf der die obere Dichtung bei minimalem Abstand aufliegt, und mit einer quer zur Bewegungsrichtung der unteren Schleusenkomponente liegenden unteren Dichtfläche, auf der die untere Dichtung bei minimalem Abstand aufliegt versehen ist.

Zum anderen ist es möglich, dass die Dichtung an der Gehäusewandung anliegt. Hierfür ist vorgesehen, dass die obere und die untere Dichtfläche jeweils durch die Innenseite der Gehäusewandung selbst gebildet wird.

Ein weiteres Merkmal ist, dass der Abstand zwischen der Dichtposition zwischen der oberen Schleusenkomponente und der Gehäusewandung sowie der Position der unteren Schleusenkomponente und der Gehäusewandung nicht konstant sondern veränderbar ist.

Der Vorteil der erfindungsgemäßen Lösungen ist darin zu sehen,
- dass ein Wechsel der oberen und unteren Schleusenhälfte ohne Bandtrennung möglich ist,
- dass ein Öffnen der Schleuse während des Betriebs möglich ist d.h. eine Bandberührung an dieser Schleuse findet nicht mehr statt,
- dass ein Öffnen der Schleuse möglich ist, ohne die Betriebsparameter der Gesamtanlage zu verändern und
- dass verschiedene Bandbreiten ohne Produktionsunterbrechungen durch die Schleuse gefahren werden können.

Die Schleuse kann auch bei einem laufenden Betrieb der Anlage außer Betrieb gesetzt werden, wodurch das Band dann nicht mehr berührt wird.

Schließlich ist der Durchmesser der verschleißbehafteten Dichtrolle variabel, da ja infolge der Relativbeweglichkeit beider Dichtrollen zueinander ein ständiger Andruck an die Substratoberflächen durch eine entsprechende Zustellung erreicht werden kann, auch wenn ein Abschleifen der Mantelfläche der Dichtrollen eingetreten ist. Insbesondere bei Dichtrollen mit einer Gestaltung der Mantelfläche mit einem flexiblen Material wird dabei eine Neubelegung der Dichtrollen mit flexiblen Material, beispielsweise eine Neugummierung, hinausgezögert.

Die Erfindung soll nachfolgend anhand eines Ausführungsbeispieles näher erläutert werden. in den zugehörigen Zeichnungen zeigt
- Fig. 1: eine erfindungsgemäße Vorrichtung einer ersten Ausführung einer Schleuse mit Dicht- und Zwischenrolle und einer zusätzlichen Dichtfläche an der Gehäusewandung im geschlossenen Zustand,
- Fig. 2: die erste Ausführungsform der Schleuse im geöffneten Zustand,
- Fig. 3: eine erfindungsgemäße Vorrichtung einer zweiten Ausführung einer Schleuse mit Dicht- und Zwischenrolle und einer als Dichtfläche ausgebildeten Gehäusewandung im geschlossenen Zustand,
- Fig. 4: die zweite Ausführungsform der Schleuse im geöffneten Zustand,
- Fig. 5: eine erfindungsgemäße Vorrichtung einer dritten Ausführung einer Schleuse mit Dichtrolle und einer zusätzlichen Dichtfläche an der Gehäusewandung im geschlossenen Zustand,
- Fig. 6: die dritte Ausführungsform der Schleuse im geöffneten Zustand,
- Fig. 7: eine erfindungsgemäße Vorrichtung einer vierten Ausführung einer Schleuse mit Dichtrolle und einer als Dichtfläche ausgebildeten Gehäusewandung im geschlossenen Zustand und
- Fig. 8: die vierte Ausführungsform der Schleuse im geöffneten Zustand.

In den Figuren ist eine Schleuse 1 als ein Teil einer Vorrichtung zur Behandlung bandförmigen Substrates 2 in einer Vakuumbeschichtungsanlage dargestellt. Eine Vakuumbeschichtungsanlage weist einen Vakuumbereich 3 auf, der durch eine Eingangs- und eine Ausgangsschleuse in der in den Zeichnungen dargestellten Art abgedichtet und mit nicht näher dargestellten Vakuumerzeugern verbunden ist.

Jede Schleuse 1 weist eine obere Schleusenkomponente 4, die oberhalb des Substrates 2 angeordnet ist, und eine untere Schleusenkomponente 5, die unterhalb des Substrates 2 angeordnet ist, auf.

Die obere 4 und die untere Schleusenkomponente 5 sind unabhängig voneinander relativ zu dem bandförmigen Substrat 2 beweglich. Dies wird dadurch realisiert, dass die obere Schleusenkomponente 4 mit einem oberen Grundrahmen 6, und die untere Schleusenkomponente 5 mit einem unteren Grundrahmen 7 verbunden ist. Der obere Grundrahmen 6 nimmt die gesamte obere Schleusenkomponente 4 und der untere Grundrahmen 7 die gesamte untere Schleusenkomponente 5 auf. Die Grundrahmen 6, 7 sind voneinander separat angeordnet sind.

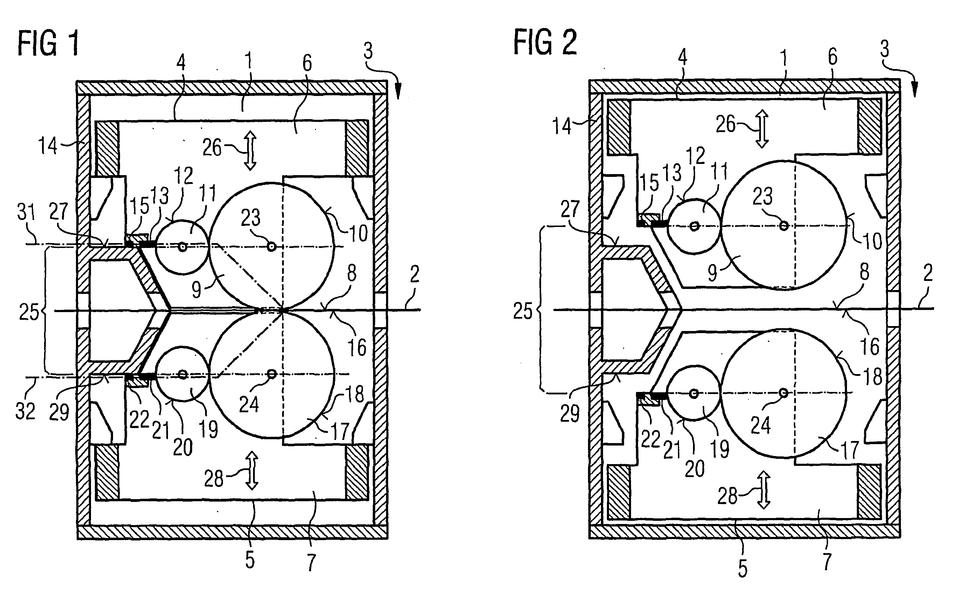

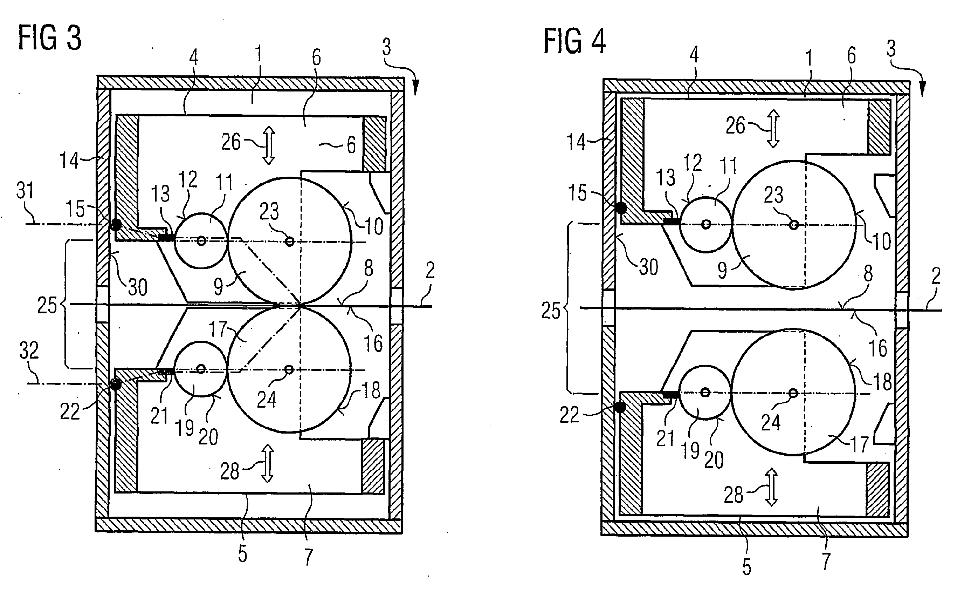

Wie in den Fig. 1 bis Fig. 4 dargestellt ist, beinhaltet die mit dem oberen Grundrahmen 6 verbundene obere Schleusenkomponente 4 eine die Oberseite 8 des Substrates 2 abdichtende obere Dichtrolle 9, eine an der Mantelfläche 10 der oberen Dichtrolle 9 anliegende obere Zwischenrolle 11 und eine an der Mantelfläche 12 der oberen Zwischenrolle 11 gleitende obere Dichtleiste 13 sowie eine an die Gehäusewandung 14 angreifende obere Dichtung 15. Die mit dem unteren Grundrahmen 7 verbundene untere Schleusenkomponente 5 beinhaltet eine die Unterseite 16 des Substrates 2 abdichtende untere Dichtrolle 17, eine an der Mantelfläche 18 der unteren Dichtrolle 17 anliegende untere Zwischenrolle 19 und eine an der Mantelfläche 20 der unteren Zwischenrolle 19 gleitende untere Dichtleiste 21 sowie eine an die Gehäusewandung 14 angreifende untere Dichtung 22.

Im statischen Zustand weisen die Mittelachsen 23, 24 der oberen 9 und der unteren Dichtrolle 17 einen Abstand 25 zueinander auf. Zum Zwecke der möglichen Relativbewegung zwischen der oberen 4 und der unteren Schleusenkomponente 5 ist dieser Abstand 25 veränderbar.

Die obere 9 und die untere Dichtrolle 17 weisen jeweils eine Mantelfläche 10, 18 aus elastischem Material und die obere 11 und die untere Zwischenrolle 19 jeweils eine Mantelfläche 12, 20 aus Stahl oder stahlähnlich hartem Material auf.

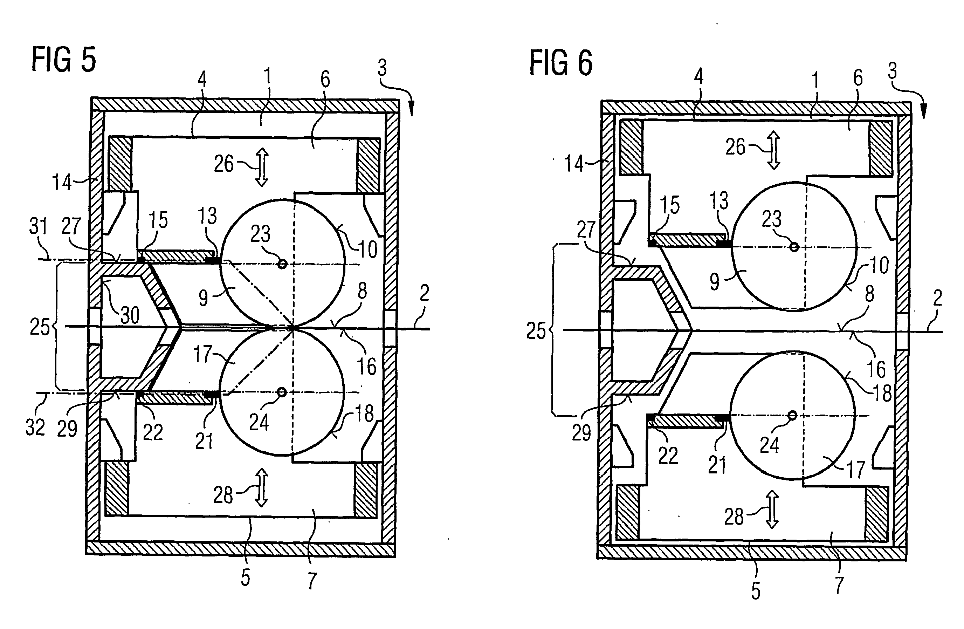

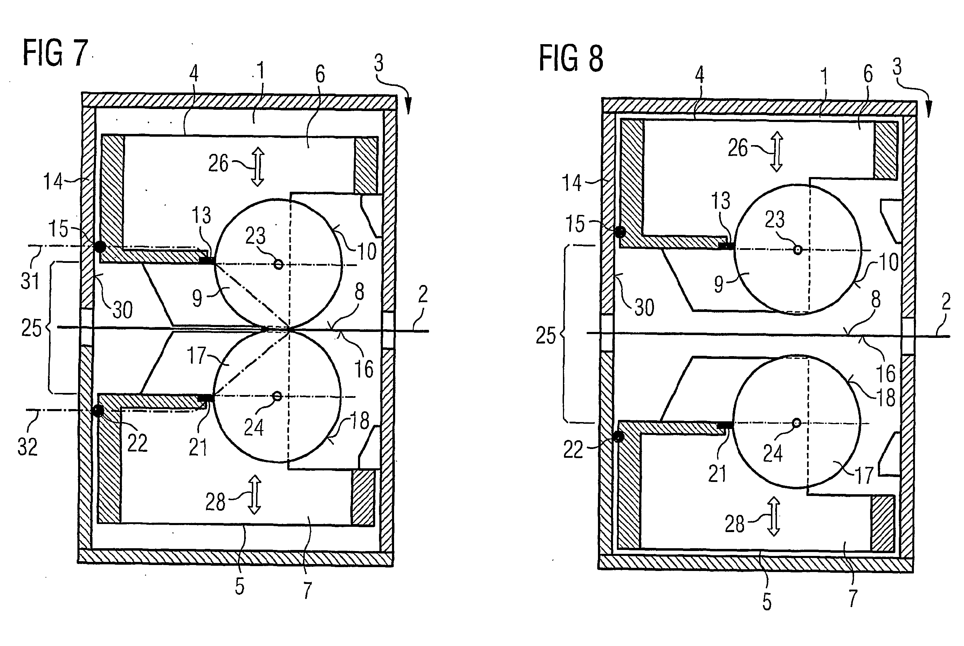

Wie in den Fig. 5 bis Fig. 8 dargestellt, beinhaltet die obere Schleusenkomponente 4, die mit dem oberen Grundrahmen 6 verbunden ist, eine die Oberseite 8 des Substrates 2 abdichtende obere Dichtrolle 9 und eine an der Mantelfläche 10 der oberen Dichtrolle 9 gleitende obere Dichtleiste 13 sowie eine an die Gehäusewandung 14 angreifende obere Dichtung 15. Die untere Schleusenkomponente 5, die mit dem unteren Grundrahmen 7 verbunden ist, beinhaltet eine die Unterseite 16 des Substrates 2 abdichtende untere Dichtrolle 17 und eine an der Mantelfläche 18 der unteren Dichtrolle 17 gleitende untere Dichtleiste 21 sowie einer an die Gehäusewandung 14 angreifende untere Dichtung 22. Diese Ausführungsform unterscheidet sich also gegenüber den in den Fig. 1 bis Fig. 4 dargestellten Varianten dadurch, dass die Dichtleisten 13, 21 auf die Dichtrollen 9, 17 direkt, d.h. ohne eine Zwischenrolle angreifen.

Auch bei dieser Ausführung weisen die Mittelachsen 23, 24 der oberen 9 und der unteren Dichtrolle 17 im statischen Zustand einen Abstand 25 zueinander auf. Zum Zwecke der möglichen Relativbewegung zwischen der oberen 4 und der unteren Schleusenkomponente 5 ist dieser Abstand 25 veränderbar.

Die obere 9 und die untere Dichtrolle 17 weisen jeweils eine Mantelfläche 10, 18 aus Stahl oder stahlähnlich hartem Material auf. Insbesondere können diese Dichtrollen 9, 17 auch aus Stahl bestehen. Die Dichtleisten 13, 21, die direkt an die Mantelflächen 10, 18 der Dichtrollen 9, 17 angreifen, bewirken somit einen relativ geringen Verschleiß. Die Dichtleisten 13, 21 sind in dieser Ausführungsform auch als Schabermesser, sogenannte Doctorblade, ausgebildet, um Verunreinigungen die an den Dichtrollen 9, 17 haften, an die die Dichtleisten 13, 21 angreifen, zu entfernen.

Die obere 15 und die untere Dichtung 22 liegen zumindest bei einem minimalen Abstand 25 an je einer Dichtfläche 27, 29, 30 der Gehäusewandung 14, wie sie weiter unten erläutert werden, dichtend an. Dabei ist in den Fig. 1 und Fig. 2 sowie in den Fig. 5 und Fig. 6 je eine Ausführung dargestellt, bei denen die Gehäusewandung 14 mit einer quer zur Bewegungsrichtung 26 der oberen Schleusenkomponente 4 liegenden oberen Dichtfläche 27 auf der die obere Dichtung 15 bei minimalem Abstand 25 aufliegt, und mit einer quer zur Bewegungsrichtung 28 der unteren Schleusenkomponente 5 liegenden unteren Dichtfläche 29, auf der die untere Dichtung 22 bei minimalem Abstand 25 aufliegt, versehen ist.

Dagegen ist in den Fig. 2 und Fig. 3 sowie Fig. 7 und Fig. 8 je eine Ausführungsform dargestellt, bei der die obere und die untere Dichtfläche jeweils durch die Innenseite 30 der Gehäusewandung 14 selbst gebildet wird.

In den Zeichnungen zeigen die Fig. 1, Fig. 3, Fig. 5 und Fig. 7 die Schleuse 1 jeweils im geschlossenen Zustand, bei dem die Dichtrollen 9, 17 jeweils am Substrat 2, d.h. am Band anliegen. Dabei entsteht über die obere Dichtung 15, die obere Dichtleiste 13, einer Berührungslinie zwischen oberer Dichtleiste 13 und Mantelfläche 12 der oberen Zwischenrolle 11, der Berührungslinie zwischen oberer Zwischenrolle 11 und oberer Dichtrolle 9, sofern eine obere Zwischenrolle 11 in der jeweiligen Ausführungsform vorhanden ist, und einer Berührungslinie zwischen oberer Dichtrolle 9 und Oberseite 8 des Substrates 2 eine geschlossene obere Dichtlinie 31 und über die untere Dichtung 22, die untere Dichtleiste 21, einer Berührungslinie zwischen unterer Dichtleiste 21 und Mantelfläche 20 der unteren Zwischenrolle 19, sofern diese in der jeweiligen Ausführungsform vorhanden ist, der Berührungslinie zwischen unterer Dichtleiste 21 und Mantelfläche 18 der unteren Dichtrolle 17 und einer Berührungslinie zwischen unterer Dichtrolle 17 und Unterseite 16 des Substrates 2 eine geschlossene untere Dichtlinie 32.

In den Zeichnungen zeigen die Fig. 2, Fig. 4, Fig. 6 und Fig. 8 die jeweilige Schleuse 1 jeweils im geöffneten Zustand, in dem die Dichtrollen 9, 17 von dem Band 2 gelöst sind. In diesem Zustand sind die Schleusenkomponenten 4, 5 auch aus der Schleuse 1 und damit aus der Vakuumbeschichtungsanlage entfernbar, ohne dass das Band 2 durchtrennt werden muss.

### Bezugzeichenliste

- 1: Schleuse
- 2: Substrat, Band
- 3: Vakuumbereich
- 4: oberen Schleusenkomponente
- 5: untere Schleusenkomponente
- 6: oberer Grundrahmen
- 7: unterer Grundrahmen
- 8: Oberseite des Substrates
- 9: obere Dichtrolle
- 10: Mantelfläche der oberen Dichtrolle
- 11: obere Zwischenrolle
- 12: Mantelfläche der oberen Zwischenrolle
- 13: obere Dichtleiste
- 14: Gehäusewandung
- 15: obere Dichtung
- 16: Unterseite des Substrats
- 17: untere Dichtrolle
- 18: Mantelfläche der unteren Dichtrolle
- 19: untere Zwischenrolle
- 20: Mantelfläche der unteren Zwischenrolle
- 21: untere Dichtleiste
- 22: untere Dichtung
- 23: Mittelachse der oberen Dichtrolle
- 24: Mittelachse der unteren Dichtrolle
- 25: Abstand
- 26: Bewegungsrichtung der oberen Schleusenkomponente
- 27: obere Dichtfläche
- 28: Bewegungsrichtung der unteren Schleusenkomponente
- 29: untere Dichtfläche
- 30: Innenseite der Gehäusewandung
- 31: obere Dichtlinie
- 32: untere Dichtlinie

## Patentansprüche

1. Verfahren zur Behandlung bandförmigen Substrates in einer Vakuumbeschichtungsanlage, wobei das bandförmige Substrat (2) auf einer Transportlinie durch die Vakuumbeschichtungsanlage, deren Vakuumbereiche (3) mittels Schleusen (1), die zumindest eine die Oberseite (8) des Substrates (2) abdichtende obere Schleusenkomponente (4) und eine die Unterseite (16) des Substrates (2) abdichtende untere Schleusenkomponente (5), sowie eine Gehäusewandung (14) aufweisen, abgetrennt sind, transportiert wird und wobei die Schleusen (1) zeitweise geöffnet werden, **dadurch gekennzeichnet, dass** bei einem Öffnen der Schleuse (1) die obere (4) und die untere Schleusenkomponente (5) unabhängig voneinander, ohne einen Durchtritt durch die Transportlinie und unabhängig von Gehäusewandung (14) bewegt werden.

2. Vorrichtung zur Behandlung bandförmigen Substrates in einer Vakuumbeschichtungsanlage mit einem durch eine Eingangs- und eine Ausgangsschleuse (1) abgedichteten Vakuumbereich (3), der mit Vakuumerzeugern verbunden ist, wobei jede Schleuse (1) einen obere Schleusenkomponente (4), die oberhalb des Substrates (2) angeordnet ist, und eine untere Schleusenkomponente (5), die unterhalb des Substrates (2) angeordnet ist, sowie eine Gehäusewandung (14) aufweist, **dadurch gekennzeichnet, dass** die obere (4) und untere Schleusenkomponente (5) unabhängig voneinander relativ zu dem bandförmigen Substrat (2) und unabhängig von Gehäusewandung (14) beweglich sind.

3. Vorrichtung nach Anspruch 2, **dadurch gekennzeichnet, dass** die beiden Schleusenkomponenten (4; 5) unabhängig voneinander aus der Vakuumbeschichtungsanlage entnehmbar sind.

4. Vorrichtung nach einem der Ansprüche 2 oder 3, **dadurch gekennzeichnet, dass** die obere Schleusenkomponente (4) mit einem oberen Grundrahmen (6), und die untere Schleusenkomponente (5) mit einem unteren Grundrahmen (7) verbunden ist, wobei der obere Grundrahmen (6) die gesamte obere Schleusenkomponente (4) und der untere Grundrahmen (7) die gesamte untere Schleusenkomponente (5) aufnimmt und die Grundrahmen (6; 7) voneinander separat angeordnet sind.

5. Vorrichtung nach Anspruch 4, **dadurch gekennzeichnet , dass** mit dem oberen Grundrahmen (6) eine die Oberseite (8) des Substrates (2) abdichtende obere Dichtrolle (9) und eine an der Mantelfläche (10) der oberen Dichtrolle (9) gleitende obere Dichtleiste (13) sowie eine an die Gehäusewandung (14) angreifende obere Dichtung (15) verbunden ist, dass mit dem unteren Grundrahmen (7) eine die Unterseite (16) des Substrates (2) abdichtende untere Dichtrolle (17) und eine an der Mantelfläche (18) der unteren Dichtrolle (17) gleitende untere Dichtleiste (21) sowie eine an die Gehäusewandung (14) angreifende untere Dichtung (22) verbunden ist, dass die Mittelachsen (23; 24) der oberen (9) und der unteren Dichtrolle (17) einen Abstand (25) zueinander aufweisen, der veränderbar ist und die obere (15) und die untere Dichtung (22) bei einem minimalen Abstand (25) an je einer Dichtfläche (27; 29; 30) der Gehäusewandung dichtend anliegen.

6. Vorrichtung nach Anspruch 5, **dadurch gekennzeichnet , dass** die obere (9) und die untere Dichtrolle (17) jeweils eine Mantelfläche (12; 18) aus Stahl oder stahlähnlich hartem Material aufweisen.

7. Vorrichtung nach Anspruch 4, **dadurch gekennzeichnet , dass** mit dem oberen Grundrahmen (6) eine die Oberseite (8) des Substrates (2) abdichtende obere Dichtrolle (9), eine an der Mantelfläche (10) der oberen Dichtrolle (9) anliegende obere Zwischenrolle (11) und eine an der Mantelfläche (12) der oberen Zwischenrolle (11) gleitende obere Dichtleiste (13) sowie eine an die Gehäusewandung (14) angreifende obere Dichtung (15) verbunden ist, dass mit dem unteren Grundrahmen (7) eine die Unterseite (16) des Substrates (2) abdichtende untere Dichtrolle (17), eine an der Mantelfläche (18) der unteren Dichtrolle (17) anliegende untere Zwischenrolle (19) und eine an der Mantelfläche (20) der unteren Zwischenrolle (19) gleitende untere Dichtleiste (21) sowie eine an die Gehäusewandung (14) angreifende untere Dichtung (22) verbunden ist, dass die Mittelachsen (23; 24) der oberen (9) und der unteren Dichtrolle (17) einen Abstand (25) zueinander aufweisen, der veränderbar ist und die obere (15) und die untere Dichtung (22) zumindest bei einem minimalen Abstand (25) an je einer Dichtfläche (27; 29; 30) der Gehäusewandung (14) dichtend anliegen.

8. Vorrichtung nach Anspruch 7, **dadurch gekennzeichnet, dass** die obere (9) und die untere Dichtrolle (17) jeweils eine Mantelfläche (10; 18) aus elastischem Material und die obere (11) und die untere Zwischenrolle (19) jeweils eine Mantelfläche (12; 20) aus Stahl oder stahlähnlich hartem Material aufweisen.

9. Vorrichtung nach einem der Ansprüche 5 bis 8, **dadurch gekennzeichnet, dass** die Gehäusewandung (14) mit einer quer zur Bewegungsrichtung (26) der oberen Schleusenkomponente (4) liegenden obere Dichtfläche (27) auf der die obere Dichtung (15) bei minimalem Abstand (25) aufliegt, und mit einer quer zur Bewegungsrichtung (28) der unteren Schleusenkomponente (5) liegenden unteren Dichtfläche (29), auf der die untere Dichtung (22) bei minimalem Abstand (25) aufliegt versehen ist.

10. Vorrichtung nach einem der Ansprüche 5 bis 8, **dadurch gekennzeichnet, dass** eine obere und eine untere Dichtfläche jeweils durch die Innenseite (30) der Gehäusewandung (14) selbst gebildet wird.

## Claims

1. Method for the treatment of strip-shaped substrate in a vacuum coating system, the strip-shaped substrate (2) being transported on a transport line through the vacuum coating system, the vacuum regions (3) of which are separated by means of locks (1) which have at least one upper lock component (4) sealing off the top side (8) of the substrate (2) and one lower lock component (5) sealing off the underside (16) of the substrate (2), and also a housing wall (14), and the locks (1) being opened intermittently, **characterized in that**, when the lock (1) is opened, the upper (4) and the lower (5) lock component are moved independently of one another and independently of the housing wall (14) without passing through the transport line.

2. Apparatus for the treatment of strip-shaped substrate in a vacuum coating system, with a vacuum region (3) which is sealed off by means of an inlet and an outlet lock (1) and which is connected to vacuum generators, each lock (1) having an upper lock component (4), which is arranged above the substrate (2), and a lower lock component (5), which is arranged below the substrate (2), and also a housing wall (14), **characterized in that** the upper (4) and the lower (5) lock component are movable independently of one another and independently of the housing wall (14) in relation to the strip-shaped substrate (2).

3. Apparatus according to Claim 2, **characterized in that** the two lock components (4; 5) can be removed from the vacuum coating system independently of one another.

4. Apparatus according to either one of Claims 2 and 3, **characterized in that** the upper lock component (4) is connected to an upper basic frame (6) and the lower lock component (5) is connected to a lower basic frame (7), the upper basic frame (6) receiving the entire upper lock component (4) and the lower basic frame (7) receiving the entire lower lock component (5), and the basic frames (6; 7) being arranged separately from one another.

5. Apparatus according to Claim 4, **characterized in that** an upper sealing roller (9) sealing off the top side (8) of the substrate (2) and an upper sealing cleat (13) sliding on the surface area (10) of the upper sealing roller (9) and also an upper seal (15) engaging on the housing wall (14) are connected to the upper basic frame (6), **in that** a lower sealing roller (17) sealing off the underside (16) of the substrate (2) and a lower sealing cleat (21) sliding on the surface area (18) of the lower sealing roller (17) and also a lower seal (22) engaging on the housing wall (14) are connected to the lower basic frame (7), and **in that** the mid-axes (23; 24) of the upper (9) and of the lower (17) sealing roller are at a distance (25) from one another which is variable, and, in the case of a minimum distance (25), the upper (15) and the lower (22) seal bear in each case sealingly against a sealing surface (27; 29; 30) of the housing wall.

6. Apparatus according to Claim 5, **characterized in that** the upper (9) and the lower (17) sealing roller have in each case a surface area (12; 18) made from steel or material having steel-like hardness.

7. Apparatus according to Claim 4, **characterized in that** an upper sealing roller (9) sealing off the top side (8) of the substrate (2), an upper intermediate roller (11) bearing against the surface area (10) of the upper sealing roller (9) and an upper sealing cleat (13) sliding on the surface area (12) of the upper intermediate roller (11) and also an upper seal (15) engaging on the housing wall (14) are connected to the upper basic frame (6), **in that** a lower sealing roller (17) sealing off the underside (16) of the substrate (2), a lower intermediate roller (19) bearing against the surface area (18) of the lower sealing roller (17) and a lower sealing cleat (21) sliding on the surface area (20) of the lower intermediate roller (19) and also a lower seal (22) engaging on the housing wall (14) are connected to the lower basic frame (7), and **in that** the mid-axes (23; 24) of the upper (9) and of the lower (17) sealing roller are at a distance (25) from one another which is variable, and, at least in the case of a minimum distance (25), the upper (15) and the lower (22) seal bear in each case sealingly against a sealing surface (27; 29; 30) of the housing wall (14).

8. Apparatus according to Claim 7, **characterized in that** the upper (9) and the lower (17) sealing roller have in each case a surface area (10; 18) made from elastic material, and the upper (11) and the lower (19) intermediate roller have in each case a surface area (12; 20) made from steel or material having steel-like hardness.

9. Apparatus according to one of Claims 5 to 8, **characterized in that** the housing wall (14) is provided with an upper sealing surface (27) which lies transversely to the direction of movement (26) of the upper lock component (4) and on which the upper seal (15) lies in the case of a minimum distance (25) and with a lower sealing surface (29) which lies transversely to the direction of movement (28) of the lower lock component (5) and on which the lower seal (22) lies in the case of a minimum distance (25).

10. Apparatus according to one of Claims 5 to 8, **characterized in that** an upper and a lower sealing surface are formed in each case by the inside (30) of the housing wall (14) itself.

## Revendications

1. Procédé de traitement de substrats en forme de bande dans une installation de revêtement sous vide, le substrat (2) en forme de bande étant transporté sur une ligne de transport dans l'installation de revêtement sous vide dont les zones (3) sous vide sont séparées au moyen de sas (1) qui présentent au moins un composant supérieur (4) de sas qui assure l'étanchéité par rapport à la partie supérieure (8) du substrat (2) et un composant inférieur (5) de sas qui assure l'étanchéité par rapport à la face inférieure (16) du substrat (2), ainsi qu'une paroi de boîtier (14), les sas (1) étant ouverts de manière cadencée,
**caractérisé en ce que**
lors de l'ouverture du sas (1), le composant supérieur (4) et le composant inférieur (5) de sas sont déplacés indépendamment l'un de l'autre sans traverser la ligne de transport et de manière indépendante de la paroi (14) du boîtier.

2. Dispositif de traitement de substrats en forme de bande dans une installation de revêtement sous vide, le dispositif présentant une zone (3) sous vide dont l'étanchéité est assurée par un sas d'entrée et un sas de sortie (1) et est reliée à des dispositifs de formation d'une dépression, chaque sas (1) présentant un composant supérieur (4) disposé au-dessus du substrat (2) et un composant inférieur (5) disposé en dessous du substrat (2), ainsi qu'une paroi (14) de boîtier, **caractérisé en ce que** le composant supérieur (4) et le composant inférieur (5) de sas sont mobiles indépendamment l'un de l'autre par rapport au substrat (2) en forme de bande et par rapport à la paroi (14) du boîtier.

3. Dispositif selon la revendication 2, **caractérisé en ce que** les deux composants (4; 5) de sas peuvent être enlevés indépendamment l'un de l'autre de l'installation de revêtement sous vide.

4. Dispositif selon l'une des revendications 2 ou 3, **caractérisé en ce que** le composant supérieur (4) de sas est relié à un bâti supérieur de base (6) et le composant inférieur (5) de sas à un bâti inférieur de base (7), le bâti de base supérieur (6) reprenant la totalité du composant supérieur (4) de sas et le bâti inférieur de base (7) la totalité du composant inférieur de sas (5), les bâtis de base (6; 7) étant disposés séparément l'un de l'autre.

5. Dispositif selon la revendication 4, **caractérisé en ce qu'**un rouleau supérieur d'étanchéité (9) qui assure l'étanchéité par rapport la face supérieure (8) du substrat (2), une languette supérieure d'étanchéité (13) qui glisse sur la surface d'enveloppe (10) du rouleau supérieur d'étanchéité (9) et un joint supérieur d'étanchéité (15) qui engage la paroi (14) du boîtier sont reliés au bâti de base supérieur (6), **en ce qu'**un rouleau inférieur d'étanchéité (17) qui assure l'étanchéité par rapport à la face inférieure (16) du substrat (2), une languette inférieure d'étanchéité (21) qui glisse sur la surface d'enveloppe (18) du rouleau inférieur d'étanchéité (17) et un joint inférieur d'étanchéité (22) qui engage la paroi (14) du boîtier sont reliés au bâti inférieur de base (7), **en ce que** les axes centraux (23; 24) du rouleau supérieur d'étanchéité (9) et du rouleau inférieur d'étanchéité (17) présentent l'un par rapport à l'autre une distance (25) qui peut être modifiée et **en ce que** le joint supérieur d'étanchéité (15) et le joint inférieur d'étanchéité (22) reposent de manière étanche sur une surface d'étanchéité respective (27; 29; 30) de la paroi du boîtier lorsque la distance (25) est minimale.

6. Dispositif selon la revendication 5, **caractérisé en ce que** le rouleau supérieur d'étanchéité (9) et le rouleau inférieur d'étanchéité (17) présentent tous deux une surface d'enveloppe (12; 18) en acier ou en un matériau dur de type acier.

7. Dispositif selon la revendication 4, **caractérisé en ce qu'**un rouleau supérieur d'étanchéité (9) qui assure l'étanchéité par rapport à la face supérieure (8) du substrat (2), un rouleau intermédiaire supérieur (11) qui repose sur la surface d'enveloppe (10) du rouleau supérieur d'étanchéité (9), une languette supérieure d'étanchéité (13) qui glisse sur la surface d'enveloppe (12) du rouleau intermédiaire supérieur (11) et un joint supérieur d'étanchéité (15) qui engage la paroi (14) du boîtier sont reliés au bâti de base supérieur (6), **en ce qu'**un rouleau inférieur d'étanchéité (17) qui assure l'étanchéité par rapport à la face inférieure (16) du substrat (2), un rouleau intermédiaire inférieur (19) qui repose sur la surface d'enveloppe (18) du rouleau inférieur d'étanchéité (17), une languette inférieure d'étanchéité (21) qui glisse sur la surface d'enveloppe (20) du rouleau intermédiaire inférieur (19) et un joint inférieur d'étanchéité (22) qui engage la paroi (14) du boîtier sont reliés au bâti inférieur de base (7), **en ce que** les axes centraux (23; 24) du rouleau supérieur d'étanchéité (9) et du rouleau inférieur d'étanchéité (17) présentent l'un par rapport à l'autre une distance (25) qui peut être modifiée et **en ce que** le joint supérieur d'étanchéité (15) et le joint inférieur d'étanchéité (22) reposent de manière étanche sur une surface d'étanchéité respective (27; 29; 30) de la paroi (14) du boîtier lorsque la distance (25) est minimale.

8. Dispositif selon la revendication 7, **caractérisé en ce que** le rouleau supérieur d'étanchéité (9) et le rouleau inférieur d'étanchéité (17) présentent chacun une surface d'enveloppe (10; 18) en un matériau élastique et **en ce que** le rouleau intermédiaire supérieur (11) et le rouleau intermédiaire inférieur (19) présentent tous deux une surface d'enveloppe (12; 20) en acier ou en un matériau dur de type acier.

9. Dispositif selon l'une des revendications 5 à 8, **caractérisé en ce que** la paroi (14) du boîtier est dotée d'une surface supérieure d'étanchéité (27) disposée transversalement par rapport à la direction de déplacement (26) du composant supérieur (4) de sas et sur laquelle le joint supérieur d'étanchéité (15) repose lorsque la distance (25) est minimale et une surface inférieure d'étanchéité (29) disposée transversalement par rapport à la direction de déplacement (28) du composant inférieur (5) de sas et sur laquelle le joint inférieur d'étanchéité (22) repose lorsque la distance (25) est minimale.

10. Dispositif selon l'une des revendications 5 à 8, **caractérisé en ce que** la surface supérieure d'étanchéité et la surface inférieure d'étanchéité sont toutes deux formées par le côté intérieur (30) de la paroi (14) du boîtier.
